# EUROPEAN PATENT APPLICATION

(11) **EP 3 883 336 A1**
(43) Date of publication of application: **22.09.2021**
(21) Application number: 20164634.6
(22) Date of filing: 20.03.2020
(51) Int. Cl.: H05B 3/06, F24H 3/04

(54) **HEATING ARRANGEMENT**

(71) Applicant: Mahle International GmbH, 70376 Stuttgart (DE)
(72) Inventor: EDEL, Nicolas, 68360 Soultz (FR); MAGNIER, Gilles, 90110 Rougemont-le-Chateau (FR); Zahnd, Audrey, 68300 Saint-Louis (FR); DAUDON, Guillaume, 88470 La Bourgonce (FR); STOECKEL, Jérôme, 68540 Bollwiller (FR)
(74) Representative: BRP Renaud & Partner mbB Rechtsanwälte Patentanwälte Steuerberater

(57) **Abstract**

The present invention relates to a heating arrangement (1) for heating an air flow, having a circuit board (3) for the energy supply and/or controlling of heating elements (2), and having at least one heating element mounting (5) arranged on the circuit board (3), into which at least one heating element (2) is or can be plugged in at a heating element slot (7) of the heating element mounting (5). The heating element mounting can comprise at least two electrically conductive conductors, each of which is electrically contacted with at least one plugged-in heating element and with the circuit board. It is substantial for the invention that on each conductor (8) an injection moulding (9) is formed through at least partial overmoulding.

## Description

The invention relates to a heating arrangement according to the preamble of Claim 1.

Such a heating arrangement usually comprises multiple heating elements, in particular PTC heating elements (PTC: positive temperature coefficient) of one or more heating bodies, in particular ceramic PTC thermistors. By means of the heating elements, an air flow, for example of room air, can be heated, wherein the heating elements are practically coupled to a circuit board in order to supply and activate the same with electric energy.

In the document EP 3 480 532 A1, an electric heating arrangement having a power unit and a control unit is described, wherein the control unit comprises an LV interface for control signals and an HV interface for a power current for operating the power unit. The control unit and the power unit are formed as a structural unit in a common housing. For creating a connection possibility of the power current and the control signals to the control unit, a standard plug element is arranged on the housing, which comprises HV plug contact elements for the power current, which are electrically connected to the HV interface, and LV plug contact elements for the control signals, which are electrically connected to the LV interfaces. Disadvantageous in this is that the heating arrangements are relatively large structures.

The object of the invention therefore lies in stating an improved or at least another embodiment of a heating arrangement. In particular an attempt is to be made to optimise the known heating arrangements in terms of the installation space that is available. In particular, a relatively compact heating arrangement is to be provided, for example in order to satisfy for example modern vehicle package requirements.

In the present invention, this object is solved in particular through the subject of the independent claim. Advantageous embodiments are subject of the dependent claims and the description.

The basic idea of the invention lies in fixing at least one electrically conductive conductor of a heating arrangement and a circuit board of the respective heating arrangement to one another by way of joint overmoulding, so that a mechanically relatively stiff and relatively compact heating arrangement is realisable.

Concretely, a heating arrangement for heating an air flow is provided according to the invention, which comprises a circuit board for the energy supply and/or controlling or regulating of heating elements of the heating arrangement. Practically, the heating elements are PTC heating elements (PTC: positive temperature coefficient). The circuit board can be a so-called PCB circuit board (PCB: printed circuit board). The heating elements are or can be plugged into a heating element mounting arranged on the circuit board in a heating element slot of the heating element mounting. Thus, the heating element mounting practically serves for locking or fixing the heating elements on the circuit board. At any rate, the heating element mounting comprises at least two electrically conductive conductors each of which is electrically contacted at one end with at least one plugged-in heating element and at the other end with the circuit board.

It is substantial for the invention that on at least one or each conductor an injection moulding is formed by way of partial or complete overmoulding, as a result of which the respective conductor is at least partly touchingly surrounded, quasi covered, by an injection moulding. For example, a plastic injection material can be used for overmoulding. When at least two conductors are provided, the overmoulding can be embodied so that the respective injection mouldings mutually touch one another or that a firmly bonded connection is formed between them. Furthermore, the overmoulding can be embodied so that the injection mouldings of at least two conductors and a circuit board of the heating arrangement mutually touch one another or that a firmly bonded connection is formed between them. Because of this, the respective conductors and/or the circuit board can be fixed to one another in a mechanically stiff manner, as a result of which the heating arrangement can be advantageously configured so as to be relatively compact. In addition, the compound of injection mouldings and/or circuit board are mechanically relatively stable, i.e. resistant to external loads on the whole. Mechanically in terms of the invention is to mean in particular that a substance-to-substance connection that can withstand external forces and moments can be formed.

Practically, at least two injection mouldings can jointly form a contiguous one-piece plug housing. By way of this, two conductors can be connected to one another, in particular mechanically. Alternatively, two conductors and the circuit board can be connected to one another, in particular mechanically, by way of the plug housing. This has the effect that the two conductors or the two conductors and the circuit board are captive and immovable relative to one another, so that the present heating arrangement is relatively stable.

Further practically, exactly two conductors can be jointly overmoulded, in particular as part of a joint overmoulding process. By way of this, the two conductors are electrically insulated relative to one another and free of mutual contact. In particular, the two conductors and the injection moulding formed through the overmoulding form a one-piece component. This has the advantageous effect that exactly two conductors are captive and immovable relative to one another.

Practically, at least one of the injection mouldings can be formed from a plastic material or a composite material. This has the advantageous effect that the heating arrangement can be realised relatively quickly and relatively cost-effectively.

Further practically, at least one conductor comprises at least one bright contact projection free of overmoulding. A contact projection each is arranged on a heating element slot. Because of this, contact projection on the one hand and heating element on the other hand are spatially arranged on the respective heating element slot relatively near to one another, so that the respective conductor is relatively easily contactable with the respective heating element.

Practically, each heating element arranged on a heating element slot is electrically contacted with a contact projection arranged on the respective heating element slot via an electrically conductive plug-in section of the respective heating element. This has the advantageous effect that electric energy for the energy supply and control of heating elements can be transmitted from the circuit board to the respective heating element. Here, an electrical and mechanical contact can be practically formed between a plug-in section and a contact projection by soldering. By way of this, the relevant circuit boards can be relatively quickly and favourably equipped with heating elements.

Practically, a plug-in section of at least one heating element is formed by a flat connector. A flat connector can for example comprise a copper pad or a copper pin. In order to be able to receive the flat connector, at least one heating element slot is practically embodied as flat connector socket that is suitable for receiving a flat connector. By way of this, an electrical contact between a flat connector of a respective heating element with a contact projection of the respective conductor can be formed in the plugged-in state of a heating element.

For the mechanical connection of a conductor with a further conductor and/or with the circuit board, an injection moulding is practically formed further by pressing, in particular by way of a press fit method or by way of soldering. This has the advantage that the heating arrangement can be realised relatively easily in terms of process.

Practically, the heating element mounting comprises at least one guiding part, which in each case serves for guiding a heating element relative to the heating element mounting. Here, each guiding part can be formed in one piece with at least one injection moulding or a plug housing formed of at least one injection moulding. For example, the respective guiding part has heating element insertion bevels or similar in order to favour the insertion of the heating element. This has the advantageous effect that the heating elements can be guided or plugged in relatively easily by means of the guiding part.

Further practically, an air-filled narrow gap can be provided between the circuit board and at least one overmoulded conductor. The narrow gap can be of constant height and a few millimetres wide throughout.

Practically, the heating element mounting can comprise a slot arrangement which has heating element plug-in rows that are arranged lined up with mutual distance from one another in a line-up direction. Each individual heating element plug-in row can in turn comprise multiple heating element slots for a single heating element each. Here it is practical that the heating element slots of a heating element plug-in row are lined up with mutual distance from one another in a transverse direction orientated transversely or at a right angle to the line-up direction, for example a few millimetres.

Further practically, the heating element slots of two heating element plug-in rows directly adjacent in the line-up direction are arranged offset relative to one another in the transverse direction. By way of this, two parallel heating element plug-in rows are quasi described, which can support two rows of heating elements.

Further practically, the heating element slots of two heating element plug-in rows that are directly adjacent in the line-up direction are arranged offset relative to one another in the transverse direction by a half or a whole or multiple heating element slots. By way of this, multiple heating elements can be advantageously arranged quasi offset relative to one another.

Practically, a slot arrangement of two directly adjacent heating element plug-in rows can be enclosed by a pair of conductors, wherein the respective conductors extend flanking the slot arrangement in the transverse direction or in the line-up direction. This has the advantageous effect that the conductors can be relatively easily run up to the heating element slots in order to contact the heating elements arranged on the respective heating element slots.

In summary it remains to be noted: the present invention preferentially relates to a heating arrangement for heating an air flow, having a circuit board for the energy supply and/or control of heating elements, and having at least one heating element mounting arranged on the circuit board, into which the at least one heating element is or can be plugged into on a heating element slot of the heating element mounting. The heating element mounting can comprise at least two electrically conductive conductors, each of which is electrically contacted with at least one plugged-in heating element and with the circuit board. It is substantial for the invention that on each conductor an injection moulding is formed through at least partial overmoulding.

Further important features and advantages of the invention are obtained from the subclaims, from the drawings and from the associated figure description by way of the drawings.

It is to be understood that the features mentioned above and still to be explained in the following cannot only be used in the respective combination stated but also in other combinations or by themselves without leaving the scope of the present invention.

Preferred exemplary embodiments of the invention are shown in the drawings and are explained in more detail in the following description, wherein same reference numbers relate to same or similar or functionally same components.

It shows, in each case schematically
- Fig. 1: a preferred exemplary embodiment of a heating arrangement according to the invention in a perspective view,
- Fig. 2: the heating arrangement from Fig. 1, however in a further perspective view deviating from Fig. 1,
- Fig. 3: the heating arrangement from Fig. 1 in a front view and finally
- Fig. 4: a further preferred exemplary embodiment of a heating arrangement according to the invention in a front view.

The drawings 1 to 4 show a heating arrangement marked in its entirety with the reference number 1 for heating a fluid, in particular room air or fluid. Heating arrangements 1 are preferably employed in motor vehicles.

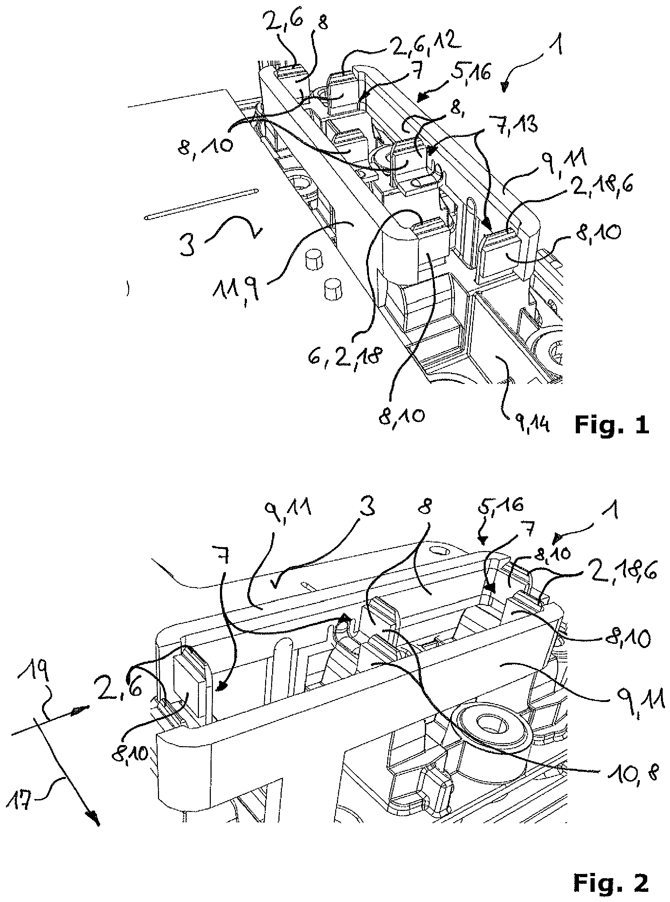

In Fig. 1 to 3, a preferred exemplary embodiment of a heating arrangement 1, in particular PTC heating arrangement, is noticeable in perspective views deviating from one another and a front view, wherein with the reference number 2 multiple heating elements are referred to, with which the actual heating of a fluid is effected. Each heating element 2 is originally formed as a freely moveable separate component; it can be commercially obtained for example. In order to operate, in particular supplied with electric energy and/or with control signals the heating elements 2, i.e. control the same, a circuit board 3 is required, in particular a PCB circuit board. The circuit board 3 accommodates the heating elements 2 permanently and in a fixed location and provides the energy supply and control of all heating elements 2 necessary for the operation.

In Fig. 1 to 3 it is evident that quasi in the region between the heating elements 2 and the circuit board 3 a device referred to as heating element mounting 5 is arranged on the circuit board 3. The heating element mounting 5 serves for receiving and in particular electrically connecting and fixing at least one heating element 2 with the circuit board 3. For this purpose, the heating element mounting 5 comprises a slot arrangement 16, which has two heating element plug-in rows 18 arranged lined up with mutual spacing relative to one another in a line-up direction 17. Each individual heating element plug-in row 18 exemplarily comprises three heating element slots 7, wherein on each heating element slot 7 one of the heating elements 2 is plugged in. The heating element slots 7 of each heating element plug-in row 18 are exemplarily lined up with mutual spacing relative to one another in a transverse direction 19 orientated at a right angle to the line-up direction 17. The heating element slots 7 of the two heating element plug-in rows 18 are arranged offset relative to one another in the transverse direction 19.

Furthermore, the heating element mounting 5 exemplarily comprises exactly two electrically conductive conductors 8, see Fig. 1 and 2. They are each connected at one end with at least one plugged-in heating element 2 and at the other end with the circuit board 3 in an electrically contacting manner. In particular in Fig. 1 it is noticeable that each conductor 8 is embodied in a partially overmoulded manner so that an injection moulding 9 each is formed on the respective conductor 8. Here, the respective overmoulding is embodied so that the injection mouldings 9 mutually contact one another and the circuit board 3. By way of this, a contiguous one-piece plug housing 11 is formed, which quasi mechanically connects the two conductors 8 and the circuit board 3 with one another.

In order to be able to form an electrically conductive connection between a plugged-in heating element 2 and a conductor 8, each heating element 2 comprises an electrically conductive bright plug-in section 6, for example a plug pin. Furthermore, each conductor 8 comprises at least one bright contact projection 10 free of overmoulding. In particular in Fig. 1 it is noticeable that the conductors 8 each have three such contact projections 10, which in each case are arranged on or in the region of a heating element slot 7, so that each heating element 2 plugged in a heating element slot 7 is arranged quasi relatively near to a respective contact projection 10. The relative proximity allows that the respective contact projection 10 is electrically contactable with the respective plug-in section 6 of a heating element 2, for example by soldering, in order to provide an electrical and mechanical contact between the respective plug-in section 6 of the respective heating element 2 and the respective contact projection 10 of the respective conductor 8.

In Fig. 1 to 3 it is noticeable, furthermore, that all plug-in sections 6 of the heating elements 2 are each formed by a flat connector 12, while the heating element slots 7 are formed as flat connector sockets 13 complementary to the flat connectors 12. This allows that a flat connector socket 13 can quasi receive a flat connector 12 of a heating element 2.

In Fig. 1 to 3 it is noticeable, furthermore, that the heating element mounting 5 or the injection mouldings 9 comprises multiple guide parts 14. These are each provided for guiding a heating element 2 relative to the heating element mounting 5. Each guide part 14 is exemplarily embodied in one piece with an injection moulding 9.

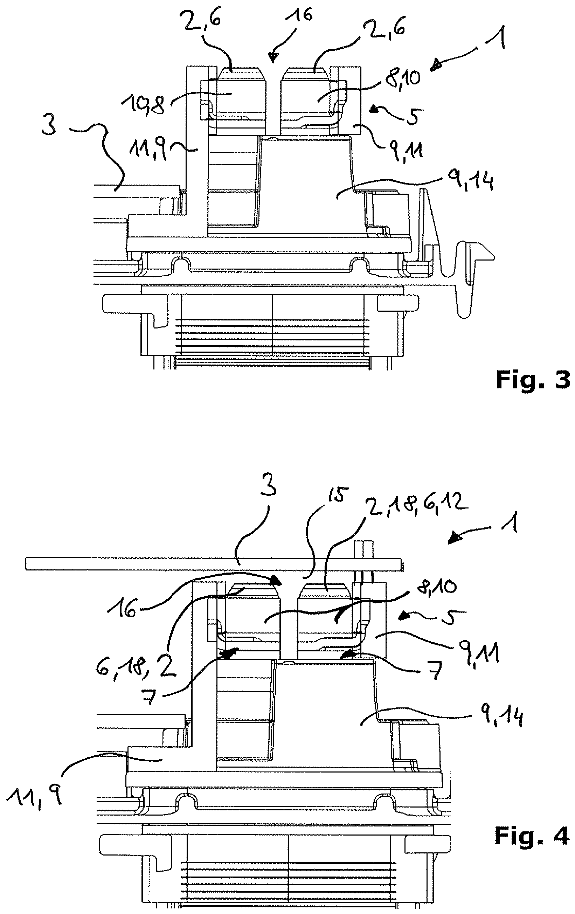

Finally, Fig. 4 shows a further preferred exemplary embodiment of a heating arrangement likewise marked with the reference number 1 in a front view. In contrast with the preceding exemplary embodiment, it is provided here that between the circuit board 3 and at least one overmoulded conductor 8, an air-filled narrow gap 15 is formed.

## Claims

1. A heating arrangement for heating an air flow,
- having a circuit board (3) for the energy supply and/or control of heating elements (2), and
- having at least one heating element mounting (5) arranged on the circuit board (3), into which at least one heating element (2) is or can be inserted at a heating element slot (7) of the heating element mounting (5),
- wherein the heating element mounting (5) comprises at least two electrically conductive conductors (8), each of which is electrically contacted with at least one inserted heating element (2) and with the circuit board (3),
**characterized**
- **in that** on each conductor (8) an injection moulding (9) is formed through at least partial overmoulding.

2. The arrangement according to Claim 1, **characterized in that** at least two injection mouldings (9) form a contiguous one-piece plug housing (11), by way of which two conductors (8) are mechanically connected to one another or by way of which two conductors (8) and the circuit board (3) are mechanically connected to one another.

3. The arrangement according to Claim 1 or 2, **characterized in that** the injection mouldings (9) are each formed from a plastic material or a composite material.

4. The arrangement according to any one of the preceding claims, **characterized in that** at least one conductor (8) comprises at least one bright contact projection (10) free of overmoulding, wherein each contact projection (10) is arranged on or in the area of a heating element slot (7).

5. The arrangement according to Claim 4, **characterized in that** each heating element (2) arranged on or in the area of a heating element slot (7) is electrically contacted via an electrically conductive plug-in section (6) of the receptive heating element (2) with a contact projection (10) that is arranged on or in the area of the respective heating element slot (7).

6. The arrangement according to Claim 5, **characterized in that** an electrical and mechanical contact between a plug-in section (6) and a contact projection (10) is formed by soldering.

7. The arrangement according to any one of the preceding Claims 5 or 6, **characterized in that** a plug-in section (6) of at least one heating element (2) is formed by a flat connector (12) and **in that** at least one heating element slot (7) is formed as a flat connector socket (13) suitable for receiving a flat connector (12).

8. The arrangement according to any one of the preceding claims, **characterized in that** an injection moulding (9) for the mechanical connection of a conductor (8) with a further conductor (8) and/or with the circuit board (3) is formed by pressing or by soldering.

9. The arrangement according to any one of the preceding claims, **characterized in that** heating element mounting (5) comprises at least one guide part (14), each of which serves for guiding a heating element (2) relative to the heating element mounting (5), wherein each guide part (14) is embodied in one piece with at least one injection moulding (9) or a plug housing (11) formed from at least one injection moulding (9).

10. The arrangement according to any one of the preceding claims, **characterized in that** between the circuit board (3) and at least one overmoulded conductor (8) an air-filled narrow gap (15) is arranged.

11. The arrangement according to any one of the preceding claims, **characterized in that** the heating element mounting (5) comprises a slot arrangement (16), which in a line-up direction (17) comprises heating element plug-in rows (18) that are arranged lined-up with mutual distance relative to one another, wherein each individual heating element plug-in row (18) comprises multiple heating element slots (7) for heating elements (2).

12. The arrangement according to Claim 11, **characterized in that** the heating element slots (7) of a heating element plug-in row (18) are lined up with mutual distance relative to one another in a transverse direction (19) orientated transversely or at a right angle to the line-up direction (17).

13. The arrangement according to Claim 12, **characterized in that** the heating element slots (7) of two heating element plug-in rows (18) that are directly adjacent in the line-up direction (17) are arranged offset relative to one another in the transverse direction (19).

14. The arrangement according to Claim 13, **characterized in that** the heating element slots (7) of two heating element plug-in rows (18) directly adjacent in the line-up direction (17), are arranged offset relative to one another in the transverse direction (19) by a half or a whole or multiple heating element slots (7).

15. The arrangement according to any one of the preceding claims, **characterized in that** a slot arrangement (16) of two directly adjacent heating element plug-in rows (18) is enclosed by a pair of conductors (8), wherein the respective conductors (8) extend in the transverse direction (19) or in the line-up direction (17) flanking the slot arrangement (16).
